(19) Europäisches Patentamt
European Patent Office
Office européen des brevets

(11) **EP 3 462 405 A1**

(12) **DEMANDE DE BREVET EUROPEEN**

(43) Date de publication:
**03.04.2019 Bulletin 2019/14**

(51) Int Cl.:
***G06Q 50/30*** *(2012.01)*    ***B60W 40/09*** *(2012.01)*

(21) Numéro de dépôt: **18185890.3**

(22) Date de dépôt: **26.07.2018**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **29.09.2017 FR 1759128**

(71) Demandeur: **IFP Energies nouvelles**
**92852 Rueil-Malmaison Cedex (FR)**

(72) Inventeurs:
• **THIBAULT, Laurent**
**92400 COURBEVOIE (FR)**
• **CORDE, Gilles**
**91430 IGNY (FR)**

(74) Mandataire: **IFP Energies nouvelles**
**Département Propriété Industrielle**
**Rond Point de l'échangeur de Solaize**
**BP3**
**69360 Solaize (FR)**

(54) **SYSTÈME DE DÉTERMINATION DYNAMIQUE DE L'EMPREINTE ENVIRONNEMENTALE LIÉE À LA MOBILITÉ GLOBALE D'UN USAGER**

(57) La présente invention concerne un système de détermination dynamique de l'empreinte environnementale liée à a mobilité globale d'un usager comprenant des moyens de mesure du déplacement de l'usager par une application sur téléphone intelligent permettant de détecter les mobilités douces et les mobilités en véhicule motorisé ainsi que le style de conduite ; des moyens de calcul de l'empreinte polluante de l'usager tenant compte de l'usage réel et des polluants globaux et locaux émis pendant une fenêtre temporelle donnée sous forme d'un serveur de calcul ou d'une électronique embarquée dans un boîtier ou dans un véhicule connecté ; des moyens d'exploitation de l'empreinte polluante comprenant un objet connecté (par exemple une vignette dynamique qualité de l'air) pour informer l'usager et/ou les autorités administratives. L'invention concerne également un procédé de détermination dynamique de l'empreinte environnementale liée à la mobilité d'un usager utilisant ledit système.

**FIG. 1**

**Description**

**Domaine technique de l'invention**

La présente invention concerne le domaine de la modélisation des émissions de polluants liées à la mobilité d'un usager, en usage réel.

L'amélioration de la qualité de l'air en milieu urbain est un enjeu majeur actuel. Pour y parvenir, l'une des pistes consiste à mettre en place des Zones réglementées à Circulation Restreinte (ZCR). Pour le moment, l'accès à ces zones est déterminé par un système de vignettes, uniquement en fonction de l'année et du carburant du véhicule. Or pour un même véhicule, les niveaux d'émissions peuvent varier du simple au triple selon le style de conduite et le parcours (circulation, pente ...). Les vignettes actuelles « qualité de l'air » ne tiennent compte que de l'année et du carburant des véhicules. L'usage du véhicule a pourtant un impact d'ordre un sur les émissions polluantes, mais le seul moyen actuellement disponible pour capter l'impact de l'usage sur les émissions est d'ajouter des systèmes de mesures à l'échappement. Il s'agit de systèmes d'instrumentation, chers, encombrants ce qui rend impossible une diffusion auprès du grand public.

**Art antérieur**

La demande de brevet française FR 3 049 653, portant sur un procédé de détermination des émissions de polluants d'un véhicule au moyen de paramètres macroscopiques, décrit un système permettant d'estimer les émissions polluantes d'un véhicule au moyen de paramètres macroscopiques, mais ne permet d'estimer le caractère polluant de la mobilité globale d'un usager à la fois lorsqu'il utilise son véhicule et d'autres modes de transports.

La demande de brevet US2004/093264 porte sur la génération de conseils d'éco-conduite avec une solution matérielle et logicielle. La solution permet d'informer le conducteur sur son empreinte relative à la consommation de carburant et à l'émission de $CO_2$. Cependant, la solution ne traite pas le volet qualité de l'air (polluants locaux), et ne permet pas d'être utilisé dans le cadre de dispositifs de restriction de la circulation. De plus, les autres moyens de transports que la voiture ne sont pas considérés.

La demande de brevet WO14/062429 « Apparatus and Methods for providing city services » porte également sur un système permettant de réduire la pollution dans les villes au moyen de capteurs. Il consiste à proposer des services aux usagers à l'aide de kiosques en faisant varier la nature et/ou le prix de ces services en fonction des conditions mesurées à l'aide de capteurs. Le système permet par exemple de faire varier le prix des places de stationnement en fonction de mesures venant d'un capteur de qualité de l'air.

La demande de brevet WO2016142733 « System and Method for use in connection on with pollutant émissions » porte sur un système permettant aux usagers de compenser les émissions polluantes de leur mobilité. Pour cela, le système permet de mesurer ou d'estimer les émissions polluantes des déplacements en voiture. Cependant, ce système ne permet pas de tenir compte de la mobilité au sens large (autre que voiture). De plus ce brevet ne décrit pas le procédé, pourtant complexe, par lequel l'estimation des émissions de polluants locaux est réalisée. Dans cette demande, l'estimation de l'empreinte polluante est utilisée pour des actions de compensation (planter des arbres par exemple).

La demande de brevet US2009/0069999 « Onboard Trip Computer for émissions subject to réduction crédit » propose un système permettant d'estimer sans instrumentation additionnelle l'empreinte carbone d'un véhicule. Pour ce faire, le système intègre des estimateurs logiciels dans le calculateur du véhicule. Un tel système est donc par nature limité aux émissions du seul véhicule. Il ne permet donc pas de considérer l'empreinte polluant globale d'un usager. De plus une telle approche nécessite la coopération des constructeurs automobile ce qui peut représenter un frein majeur pour une ville qui souhaiterait mettre en place un système de régulation de la circulation basé sur l'empreinte polluante.

La demande de brevet US20140039988 « Method and System for Controlling Traffic Pollution » concerne un système permettant d'estimer l'empreinte polluante d'un véhicule dans le but de réguler le trafic dans certaines zones, mais il ne permet pas d'estimer l'empreinte de la mobilité d'un usager au sens large (bus, vélo, marche). Mais il est nécessaire d'équiper le véhicule avec un appareil de mesure des émissions polluantes. Ce point implique des coûts de diffusion à grande échelle très importants pour ce système.

Le modèle d'utilité chinois CN205010009U « Automobile pollution monitoring device » porte également sur un système permettant de mesurer les émissions polluantes en usage réel d'un véhicule. Il est cependant nécessaire d'instrumenter le véhicule ; par ailleurs le système ne prend pas en compte les émissions liées à la mobilité autre que voiture.

La présente invention permet de pallier l'ensemble des défauts recensés dans l'art antérieur.

Notamment la présente invention propose un système complet permettant, sans aucun capteur additionnel, de mesurer l'usage et la mobilité du conducteur pour ensuite autoriser ou non son accès à certaines zones. Cela est possible via l'utilisation d'une application sur téléphone intelligent (également appelée ci-après application smartphone) ou directement via l'interface d'un véhicule connecté, couplée à des modèles de calculs sur serveurs qui permettent de se passer d'un réseau de capteurs physiques.

La présente invention prévoit en effet le recours à des modèles de calcul d'estimation des polluants locaux sur serveur, ce qui permet de réaliser cette estimation des polluants locaux les plus courants sans capteur additionnel, ce qui représente un bénéfice important pour une diffusion à grande échelle du système. Par ailleurs, la finalité du système selon l'invention est de permettre à l'utilisateur d'agir sur son empreinte polluante en temps réel afin notamment de lui donner l'accès à des zones de circulation limitées.

**Objet de l'invention**

La présente invention porte sur un procédé et un système complet permettant d'estimer le niveau d'émissions polluantes en usage réel du véhicule, c'est à dire tenant compte à la fois du véhicule, mais également de l'usage qui en est fait. L'invention porte également sur une vignette qualité de l'air connectée permettant d'exploiter de manière dynamique les informations fournies par le système. Pour permettre une diffusion à large échelle, la présente solution peut être déployée avec comme seul capteur un smartphone.

La présente invention concerne *plus particulièrement* un système de détermination des émissions polluantes en usage réel, au centre duquel se trouve un objet connecté permettant de remplacer les vignettes actuelles « qualité de l'air » statiques, par une notation dynamique tenant compte de l'usage. Il devient ainsi possible d'instaurer des Zones de Circulation Restreinte (ZCR) tenant compte du comportement des usagers et pas uniquement de l'année de leur véhicule.

Pour ce faire, l'invention propose une solution complète matérielle et logicielle permettant de mesurer automatiquement et dynamiquement les émissions polluantes complètes (polluants locaux et globaux) résultantes de la technologie du véhicule et de l'usage (style de conduite et modes de transports utilisés), de calculer et d'afficher l'empreinte polluante associée et de communiquer avec l'infrastructure, par exemple pour donner accès à des zones limitées. Cette solution est diffusable à grande échelle de par son coût réduit, résultat d'une instrumentation minimale du véhicule et de l'emploi de briques d'estimations logicielles.

Les polluants locaux désignent notamment les oxydes d'azote (NOx), les particules fines, les monoxydes de carbone (CO), les hydrocarbures non brûlés (HC), le dioxyde de soufre, tandis que les polluants globaux font majoritairement référence au $CO_2$ et aux gaz à effet de serre.

**Résumé de l'invention**

L'invention concerne un système de détermination dynamique de l'empreinte environnementale liée à la mobilité globale d'un usager comprenant:

a) des moyens de mesure du déplacement de l'usager par une application sur téléphone intelligent permettant de détecter les mobilités douces et les mobilités en véhicule motorisé ainsi que le style de conduite ;
b) des moyens de calcul de l'empreinte polluante de l'usager tenant compte de l'usage réel et des polluants globaux et locaux émis pendant une fenêtre temporelle donnée sous forme d'un serveur de calcul ou d'une électronique embarquée dans un boîtier ou dans un véhicule connecté ;
c) des moyens d'exploitation de l'empreinte polluante comprenant un objet connecté pour informer l'usager et/ou les autorités administratives.

De préférence, l'objet connecté comprend au moins :

a) des moyens d'affichage de l'empreinte environnementale
b) des moyens de communication avec le téléphone intelligent, le serveur et l'infrastructure routière ;
c) des moyens d'identification du véhicule
d) des moyens d'alimentation et de stockage de l'énergie.

Les moyens de mesure peuvent comprendre un boîtier connecté et/ou un véhicule connecté et/ou une montre connectée.

Les moyens de calcul de l'empreinte polluante peuvent mettre en oeuvre un capteur physique embarqué pour des polluants locaux spécifiques.

Les moyens d'exploitation de l'empreinte polluante peuvent comprendre des moyens de communication avec l'infrastructure routière.

De préférence, l'objet connecté est une vignette « qualité de l'air » dynamique.

De manière avantageuse, ladite vignette « qualité de l'air» communique directement l'empreinte environnementale à l'infrastructure routière pour l'accès de l'usager à des zones de circulation restreinte ou de stationnement préférentiel.

De préférence, ladite vignette « qualité de l'air » affiche l'empreinte environnementale de l'usager, notamment au moyen d'un code couleur ou d'un indicateur.

Dans un autre mode de réalisation, l'objet connecté est intégré au téléphone intelligent ou au boîtier connecté ou au véhicule connecté ou à la montre connectée.

L'invention concerne également un procédé de détermination dynamique de l'empreinte environnementale liée à la mobilité d'un usager utilisant ledit système et comprenant les étapes suivantes :

a) Mesure du déplacement de l'usager par une application sur téléphone intelligent détectant les mobilités douces et les mobilités en véhicule motorisé, ainsi que le style de conduite ;

b) Calcul de l'empreinte polluante de l'usager pour une fenêtre temporelle donnée tenant compte de l'usage réel et des polluants globaux et locaux émis pendant cette fenêtre temporelle ;

c) Affichage de l'empreinte environnementale liée à la mobilité de l'usager et information de l'usager et des autorités administratives par connexion cellulaire ou sans fil.

Le calcul de l'empreinte polluante peut être effectué par agrégation de l'ensemble des émissions polluantes liées aux polluants locaux et globaux dans un seul référentiel, ledit référentiel étant obtenu en réalisant une somme pondérée des émissions de chaque polluant considérés en gramme par kilomètre, lesdits coefficients de cette somme pondérée étant choisis en fonction de leur impact sur la santé et l'environnement.

Pour le calcul de l'empreinte polluante, on peut calculer les émissions de polluants liées au véhicule motorisé utilisé par l'usager en acquérant au moins un paramètre macroscopique relatif à la conception dudit véhicule, et en construisant pour ledit véhicule :

- un modèle dudit véhicule qui relie ladite position et/ou l'altitude et/ou la vitesse dudit véhicule au couple et au régime dudit moteur au moyen d'au moins un paramètre macroscopique ;
- un modèle dudit moteur qui relie ledit couple et ledit régime dudit moteur aux émissions de polluants en sortie dudit moteur au moyen d'au moins un paramètre macroscopique ; et
- optionnellement un modèle dudit système de post-traitement qui relie lesdites émissions de polluants en sortie dudit moteur au moyen aux émissions de polluants en sortie dudit système de post-traitement au moyen d'au moins un paramètre macroscopique ;

et en réalisant les étapes suivantes :

- on mesure la position, l'altitude et la vitesse dudit véhicule au moyen d'un système de géolocalisation ou d'un téléphone portable ;
- on détermine ledit couple (Cme) et ledit régime (Ne) dudit moteur au moyen dudit modèle de véhicule et desdites mesures ;
- on détermine les émissions de polluants en sortie dudit moteur au moyen dudit modèle du moteur et dudit couple (Cme) et dudit régime (Ne) dudit moteur ; et
- éventuellement on détermine les émissions de polluants du véhicule au moyen dudit modèle du système de post-traitement et desdites émissions de polluants en sortie dudit moteur.

De préférence, on calcule d'abord une empreinte polluante pour chaque trajet j, puis on calcule une empreinte polluante moyenne pour l'ensemble des n trajets intervenus sur ladite fenêtre temporelle, comprenant ou non les trajets en mobilités douces, j étant un entier allant de 1 à n.

De préférence, ladite fenêtre temporelle est comprise entre 1 jour et 1 mois.

De préférence, les polluants globaux sont choisis parmi le dioxyde de carbone et autres gaz à effet de serre et les polluants locaux sont choisis parmi les oxydes d'azote, le monoxyde de carbone, les particules fines, les hydrocarbures imbrûlés, le dioxyde de soufre.

## Présentation succincte des figures

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre les étapes du procédé de détermination des émissions polluantes et les moyens associés du système selon l'invention.

La figure 2 illustre l'écosystème de la vignette connectée selon l'invention, notamment les interfaces permettant les échanges.

**Description détaillée de l'invention**

L'invention a pour vocation de transformer le dispositif de restriction de la circulation actuel, basé sur des vignettes « statiques » tenant compte uniquement de la technologie du véhicule, en une vignette connectée capable de capter également l'usage et le comportement du conducteur. Le système de détermination dynamique des émissions polluantes selon l'invention permet de remettre le conducteur au centre de l'amélioration de la qualité de l'air en le sensibilisant sur son impact et en l'incitant à s'améliorer. Concrètement, cela signifie que le niveau de certificat de qualité de l'air est dynamique et peut varier selon l'usage du conducteur. L'usage pris en compte peut être le style de conduite (conduite agressive ou douce) et/ou les modes de transports retenus, notamment le fait de privilégier les modes de transports doux sur les courts trajets.

Figure 1 :

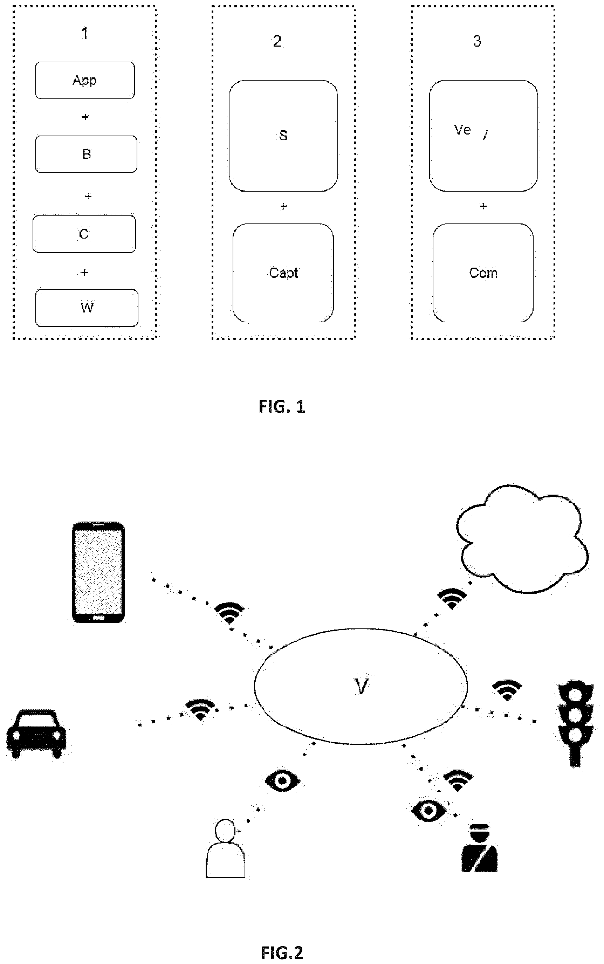

Comme illustré sur la Figure 1, le fonctionnement de la vignette connectée (V) permettant la détermination des émissions polluantes en usage réel, selon l'invention, peut être décomposé en trois étapes :

1. Mesure de l'usage au moyen d'une application sur téléphone intelligent, et en option sur un boîtier connecté ou un véhicule connecté ou une montre connectée ou tout objet connecté analogue.
2. Calcul de l'empreinte polluante, faisant appel à un serveur de calcul ou une électronique embarquée, de manière optionnelle le système peut faire appel à un capteur embarqué pour certains polluants spécifiques.
3. Exploitation de l'empreinte polluante sous forme d'un objet connecté informant le conducteur et les autorités (vignette dynamique), de manière optionnelle communication avec l'infrastructure routière pour autoriser l'accès à certaines zones.

Plus précisément, le procédé selon l'invention comprend les étapes suivantes :
La première étape consiste à mesurer l'usage, c'est-à-dire principalement le style de conduite, mais également de manière optionnelle les modes de transports alternatifs utilisés (vélo, bus,...). Cette mesure sera principalement basée sur le capteur GNSS (Global Navigation Satellite System pour système de navigation satellite global) d'un téléphone intelligent pour faciliter la diffusion du système, au moyen d'une application smartphone (App). Optionnellement, d'autres capteurs pourront être ajoutés dans le but d'améliorer la précision. Ces capteurs peuvent par exemple être un boitier (B) connecté branché sur la prise OBD du véhicule, une communication directe avec le véhicule (Ve) dès lors que celle-ci est disponible ou encore une montre connectée (W) permettant de capter finement les modes de transports alternatifs (mobilités douces).

*A. Détection des mobilités douces*

Les mobilités douces, i.e. non émettrices, doivent être prises en compte dans l'évaluation de l'empreinte environnementale de la mobilité globale, car elles peuvent être des choix de substitution à des solutions de mobilités polluantes. Le système selon l'invention permet ainsi la détection automatique de la marche, de la course et du vélo, et ce en limitant au maximum la consommation de la batterie.

*B. Détection des déplacements en véhicule motorisé*

Le système selon l'invention détecte de manière automatique via un téléphone intelligent les déplacements en véhicules motorisés, en maximisant la sensibilité de détection du début de chaque trajet et la précision des données recueillies, tout en limitant la consommation de batterie de la fonction. Cette fonction ne nécessite pas l'utilisation permanente de la géolocalisation (GNSS). Elle se base sur l'observation des changements d'antenne GSM, et/ou sur l'identification du type d'activité de l'utilisateur, détaillé dans le bloc précédent. Lorsqu'un changement d'antenne est détecté ou que l'activité actuellement détectée est de la voiture, le capteur GNSS du smartphone est activé pendant un temps donné. Si les mesures de vitesses enregistrées correspondent bien à un cas d'utilisation de véhicule motorisé alors l'enregistrement d'un nouveau trajet en véhicule motorisé est lancé et le GNSS reste activé jusqu'à la fin de celui-ci. Au cours du trajet, les signaux de vitesse et d'altitude sont enregistrés à chaque instant, ce qui permet de tenir compte du style de conduite de manière intrinsèque. La fin du trajet est déterminée par une condition sur la vitesse. En fin de trajet, les données enregistrées sont envoyées sur un serveur ou stockées en local pour un envoi ultérieur (cas notamment de l'absence réseau en fin de trajet).
L'identification du véhicule motorisé utilisé sur chaque trajet peut être réalisée soit de manière déclarative par l'utilisateur soit de manière automatisée en comparant la route suivie avec certaines routes connues (tramway, bus,...)

La deuxième étape consiste à calculer l'empreinte polluante. Ce calcul est tout d'abord réalisé trajet par trajet, puis l'on calcule une empreinte moyenne sur une fenêtre temporelle donnée (par exemple 1 jour, 1 semaine ou 1 mois). Cette moyenne peut tenir compte ou non des mobilités douces. Ce calcul peut être déporté sur un serveur de calcul (S) (cas sans boitier dans le véhicule) ou hébergé directement dans l'électronique du boîtier ou du véhicule connecté (électronique embarquée). Optionnellement, un capteur physique embarqué (Capt) peut être ajouté au système pour améliorer sa précision.

Pour l'obtention de l'information globale portant sur l'empreinte environnementale d'un trajet en véhicule motorisé, la présente invention peut utiliser une approche macroscopique telle que décrite dans la demande de brevet FR 3 049 653 utilisant un procédé de détermination des émissions de polluant d'un véhicule dans lequel on construit un modèle du véhicule, un modèle du moteur et un modèle du système de post-traitement, et on mesure la position, l'altitude et la vitesse du véhicule au moyen d'un système de géolocalisation ou d'un téléphone portable. Les mesures et les modèles sont utilisés pour déterminer les émissions de polluants globaux et locaux. Notamment, le calcul des émissions polluantes du véhicule utilisé par l'usager comportant un moteur à combustion interne et éventuellement un système de post-traitement des gaz d'échappement dudit moteur peut être effectué au moyen d'un procédé de détermination des émissions de polluants d'un véhicule, dans lequel on acquiert au moins un paramètre macroscopique relatif à la conception dudit véhicule, et dans lequel on construit pour ledit véhicule :

i) un modèle dudit véhicule qui relie ladite position et/ou l'altitude et/ou la vitesse dudit véhicule au couple et au régime dudit moteur au moyen d'au moins un paramètre macroscopique ;
ii) un modèle dudit moteur qui relie ledit couple et ledit régime dudit moteur aux émissions de polluants en sortie dudit moteur au moyen d'au moins un paramètre macroscopique ; et
iii) optionnellement un modèle dudit système de post-traitement qui relie lesdites émissions de polluants en sortie dudit moteur au moyen aux émissions de polluants en sortie dudit système de post-traitement au moyen d'au moins un paramètre macroscopique ;

caractérisé en ce qu'on réalise les étapes suivantes :

a) on mesure la position, l'altitude et la vitesse dudit véhicule au moyen d'un système de géolocalisation ou d'un téléphone portable ;
b) on détermine ledit couple (Cme) et ledit régime (Ne) dudit moteur au moyen dudit modèle de véhicule et desdites mesures ;
c) on détermine les émissions de polluants en sortie dudit moteur au moyen dudit modèle du moteur et dudit couple (Cme) et dudit régime (Ne) dudit moteur ; et
d) optionnellement on détermine les émissions de polluants du véhicule au moyen dudit modèle du système de post-traitement et desdites émissions de polluants en sortie dudit moteur.

Plus précisément, le système selon l'invention peut faire appel à un calcul de l'empreinte environnementale globale de la mobilité d'un sujet sur une fenêtre temporelle donnée ou sur un trajet donné tenant compte du style de conduite faisant appel à une détection des mobilités douces non émettrices de polluant et une détection des déplacements en véhicule motorisé et de leurs émissions polluantes associées comme décrit ci-dessus. A cet effet, l'ensemble des émissions polluantes générées par chacun des déplacements pendant une durée donnée, par exemple au cours de la journée (quel qu'en soit le mode) sont agrégées dans un référentiel unique, où les différents polluants sont pris en compte proportionnellement à leur dangerosité.

Le référentiel des points polluants est obtenu en réalisant une somme pondérée des émissions de chaque polluant considérés en gramme par kilomètre. Les coefficients de cette somme pondérée sont choisis pour être représentatifs de l'impact sur la santé et la planète des différents polluants. Ce choix peut par exemple s'appuyer sur « la méthodologie des coûts externes » proposée notamment par la commission européenne.

Calcul de l'empreinte environnementale du trajet en tenant compte du style de conduite

De manière avantageuse, pour chaque trajet $j$ réalisé à l'aide d'un véhicule $k$, on peut calculer une valeur $POPS_{j,k}$ en réalisant la somme pondérée des émissions cumulées de chaque polluant i. Les différents polluants sont pris en compte proportionnellement à leur dangerosité. Les facteurs de pondération aides différents polluants ont été calculés à l'aide de la méthodologie des coûts externes (état de l'art de l'impact sociétal). Ces facteurs sont l'image de la dangerosité de chaque polluant et sont indépendants du véhicule.

$$POPS_{j,k} = \sum_i \alpha_i \times \phi_{i,j,k}^{[\frac{g}{km}]}$$

Une liste non exhaustive des polluants considérés est donnée ci-dessous :

- dioxyde de carbone, gaz à effet de serre
- oxydes d'azote,
- monoxyde de carbone
- particules fines
- hydrocarbures imbrûlés
- dioxyde de soufre.

Dans le cas d'un transport partagé (transport en commun ou covoiturage), une pondération peut être appliquée pour normaliser les émissions par le nombre d'usagers.

Les émissions $\phi_{i,j,k}^{[\frac{g}{km}]}$ cumulées de chaque polluant $i$ sur le trajet $j$ avec le véhicule $k$ sont alors calculées en intégrant les émissions instantanées sur le trajet $\psi_{i,j,k}^{[\frac{g}{h}]}(t)$, elle-même calculées à l'aide de modèles de polluant, par exemple comme décrits ci-dessus (approche macroscopique).

D'un point de vue macroscopique, ce calcul peut être exprimé par les équations suivantes :

$$\begin{cases} \phi_{i,j,k}^{[\frac{g}{km}]} = \int_{t_i}^{t_f} \psi_{i,j,k}^{[\frac{g}{h}]}(t)\, dt \\ \psi_{i,j,k}^{[\frac{g}{h}]}(t) = f_k(V_j(t), Alt_j(t), T_j(t), spec_k) \end{cases}$$

avec :

- $V_j(t)$ la vitesse véhicule et $Alt_j(t)$ les profils de vitesse et d'altitude mesurés par le GNSS sur le trajet j
- $T_j(t)$ la température extérieure, recalculée à partir des coordonnées GNSS
- $f_k$ le modèle retenu pour le véhicule $k$ et $spec_k$ les spécifications technologiques du véhicule utilisées pour paramétrer les modèles sont par exemple :

    - le type de motorisation (essence, Diesel,..)
    - le niveau de norme d'homologation (Euro 1, Euro 2, ...)
    - la cylindrée
    - le couple maximal et le régime moteur associé
    - la puissance maximale et le régime moteur associé
    - la masse du véhicule
    - le type de boîte de véhicule
    - le type de système de post traitement
    - le type de système d'injection
    - le niveau d'hybridation

Calcul de l'empreinte environnementale globale de la mobilité sur une fenêtre temporelle donnée

L'ensemble des empreintes polluants générés par chacun des déplacements au cours de la fenêtre temporelle, par exemple la journée (quel qu'en soit le mode), sont agrégées pour fournir un indicateur unique pour la fenêtre temporelle donnée. Sur une journée, par exemple, cette agrégation est faite en calculant une moyenne pondérée par les distances parcourues de chaque trajet $d_j^{[km]}$ à l'aide de la formule suivante

$$POPS_{jour} = \frac{\sum_j d_j^{[km]} * POPS_{j,k}}{\sum_j d_j^{[km]}}$$

Enfin l'information sur l'empreinte environnementale peut être restituée à l'utilisateur sous la forme d'un objet connecté V présent dans le véhicule dont la couleur varie par exemple pour indiquer le niveau de vignette qualité de l'air équivalent (vignette qualité de l'air dynamique) ou directement sur le téléphone intelligent ou l'interface d'affichage du véhicule connecté. Alternativement à la couleur, l'empreinte environnementale peut être restituée à l'utilisateur sous la forme d'un indicateur chiffré, au niveau d'une vignette, d'un téléphone intelligent ou tout objet connecté analogue. Cet objet connecté peut également optionnellement communiquer directement avec l'infrastructure routière pour autoriser l'entrée dans des zones à circulation restreinte (Com).

Figure 2 :

La Figure 2 représente le système selon l'invention et son écosystème afin d'expliciter quels sont les échanges et les interfaces de la vignette connectée V.

*Interface avec le conducteur et les autorités*

*- Contrôle visuel*

La vignette connectée V permet un retour d'information visuel pour le conducteur sur l'empreinte polluante de sa mobilité. Cette information peut également être contrôlée visuellement par les autorités, au même titre que les vignettes qualité de l'air actuelles. La vignette peut ainsi changer de couleur en fonction selon la valeur de l'empreinte environnementale du véhicule et de son usage. Par exemple, une palette à dix couleurs peut ainsi être utilisée avec par intensité d'émission polluante : vert moyen, vert clair, bleu-vert, bleu, violet ; jaune clair, jaune, orange, rose, rouge, afin de donner une empreinte polluante allant de la moins polluante vers la plus polluante. L'utilisation des couleurs permet un contrôle visuel direct de l'empreinte polluante du véhicule.

- Contrôle par transmission sans fil

Les autorités peuvent également, par transmission des données, suivant différents dispositifs de réception (bluetooth, wifi, cellulaire...) recevoir le score d'émission polluante émise lors d'un contrôle sur un périmètre donné.

*Interface avec l'application smartphone*

L'application smartphone (ou application pour téléphone intelligent) remplit plusieurs fonctions :

- Permettre à l'utilisateur de renseigner sa plaque d'immatriculation afin de connaître les spécificités techniques de son véhicule.
- Détecter ses déplacements en voiture et enregistrer sa trace GNSS instantanée (pente et vitesse). Lors de la communication avec la vignette connectée, il est ainsi utile de transmettre un identifiant unique permettant de savoir quel véhicule est utilisé.
- Détecter les modes de déplacements alternatifs (bus, vélo, marche) de l'usager pour mesurer l'empreinte polluant globale de l'usager et pas seulement la part liée à son véhicule. Si l'utilisateur est équipé d'une montre connectée, les capteurs de celle-ci sont automatiquement pris en compte, car couplés à son smartphone.

*Interface avec le véhicule ou un boitier connecté*

Optionnellement, la vignette connectée peut échanger avec un boitier connecté ou directement avec le véhicule. Cette échange permet de remonter des mesures supplémentaires afin d'affiner l'estimation des polluants.

Dans le cas d'un boîtier connecté, un branchement sur la prise OBD (On Board Diagnosis) permet avantageusement de lire des messages circulant sur l'OBD ainsi que sur le bus CAN (Control Area Network), comme le régime moteur instantané par exemple. Ces informations peuvent être transmises soit directement au serveur à l'aide d'une connexion à un réseau cellulaire (de type 4G), soit en passant par le téléphone intelligent à l'aide d'une communication sans fil (bluetooth par exemple). Cette architecture d'échange peut également être utilisée pour communiquer directement avec un véhicule sans boîtier, si un véhicule le permet.

Le boîtier connecté peut également éventuellement héberger le calcul des émissions polluantes afin de se passer du smartphone et de la connexion au serveur.

*Interface avec le serveur*

Le serveur peut héberger le calcul des émissions polluantes. Il peut ainsi communiquer directement le résultat de l'empreinte polluant à la vignette ou indirectement en passant par le smartphone. De manière avantageuse, le serveur héberge également une base de données des émissions en usage réel qui permet aux villes de réaliser un suivi dynamique et une projection des niveaux d'émissions de l'ensemble des utilisateurs sur une cartographie de leur territoire.

*Interface avec l'infrastructure routière*

La vignette connectée ou l'objet connecté peuvent directement communiquer avec l'infrastructure routière pour conférer des avantages récompensant les conducteurs ayant une empreinte polluants réduite. Ces avantages peuvent par exemple être :

- L'accès à certaines zones à circulation restreinte ;
- L'accès à des conditions préférentielles à certains parkings ;
- Des réductions à certains péages.

Une variante de l'invention consiste à dématérialiser la vignette connectée. Dans ce cas les échanges ne sont plus centralisés dans la vignette connectée (qui n'existe plus), mais directement dans le téléphone intelligent. Dans ce cas, c'est directement le téléphone intelligent qui vient communiquer avec l'infrastructure et les autorités pour afficher le niveau d'empreinte polluant de l'usager ainsi que ses autorisations de circuler associées.

Dans un autre mode de réalisation, lorsque le véhicule est un véhicule connecté, l'application smartphone et/ou la vignette connectée sont directement intégrées au véhicule.

**Vignette dynamique « qualité de l'air » connectée**

La vignette dynamique « qualité de l'air» connectée se compose avantageusement de quatre modules :

- Le module d'affichage de l'empreinte environnementale permet au moyen d'un écran ou de LED de représenter un code couleur ou un indicateur chiffré permettant au conducteur et aux autorités de déterminer la classe d'empreinte polluants du véhicule en usage réel ;
- Le module de communication permet :

  • d'une part d'échanger avec le serveur et/ou le smartphone et/ou le boîtier et/ou le véhicule connecté afin de récupérer l'information « empreinte environnementale »
  • et d'autre part de communiquer avec l'infrastructure (péage, barrières,...) afin d'autoriser l'accès à certaines zones.

- Le module d'identification du véhicule permet de communiquer au smartphone un identifiant unique associé à chaque véhicule, par exemple en renseignant la plaque minéralogique du véhicule motorisé. Il est ainsi possible de déterminer avec précision les débuts et fin de trajet, ainsi que les caractéristiques du véhicule utilisé pour le trajet.
- Le module d'alimentation et de stockage de l'énergie permet d'avoir un objet alimenté de manière autonome, par exemple par une batterie.

L'innovation majeure de l'invention est de pouvoir prendre en compte l'usage réel, sans instrumentation du véhicule, sans une étape de paramétrage complexe par l'utilisateur et avec un temps de calcul très court. Ces trois points font que le système, le procédé et la vignette connectée selon l'invention sont adaptés à un déploiement à grande échelle, ce qui n'est pas le cas des solutions alternatives.

Plus précisément, les avantages de l'invention par rapport à une vignette qualité de l'air classique et par rapport aux procédés de détermination des émissions polluantes selon l'art antérieur sont donc :

- La possibilité de mesurer l'empreinte globale de la mobilité d'un usager, et pas seulement celle liée à ses déplacements en voiture.
- La possibilité de mesurer l'empreinte polluant d'un usager sans capteur additionnel.

- La solution peut être facilement déployée à grande échelle grâce à un coût réduit (via l'utilisation d'une application smartphone pour estimer l'empreinte polluant) par rapport à des stations de mesures des polluants.
- L'invention rend possible pour les villes de réglementer l'accès à des zones de circulation restreinte en tenant compte de l'usage et pas seulement de la technologie du véhicule.
- L'invention permet une meilleure représentativité grâce à la captation de l'usage.
- L'invention permet une sensibilisation des usagers sur leur responsabilité et leur levier d'action sur la qualité de l'air
- L'acceptabilité par le grand public devient meilleure : dans le système actuel, le droit de circuler est directement fonction de l'année, et donc indirectement de la valeur du véhicule ce qui est discriminant d'un point de vue social. Avec la vignette qualité de l'air selon l'invention, chacun peut obtenir des droits de circuler plus importants en adaptant l'usage qu'il fait de son véhicule
- Pour les villes, il devient possible de contrôler directement l'efficacité environnementale de l'infrastructure et de la réglementation associée.

**Revendications**

1. Système de détermination dynamique de l'empreinte environnementale liée à la mobilité globale d'un usager comprenant:

    a) des moyens de mesure du déplacement de l'usager par une application sur téléphone intelligent permettant de détecter les mobilités douces et les mobilités en véhicule motorisé ainsi que le style de conduite ;
    b) des moyens de calcul de l'empreinte polluante de l'usager tenant compte de l'usage réel et des polluants globaux et locaux émis pendant une fenêtre temporelle donnée sous forme d'un serveur de calcul ou d'une électronique embarquée dans un boîtier ou dans un véhicule connecté ;
    c) des moyens d'exploitation de l'empreinte polluante comprenant un objet connecté pour informer l'usager et/ou les autorités administratives.

2. Système selon la revendication 1 dans lequel l'objet connecté comprend au moins :

    a) des moyens d'affichage de l'empreinte environnementale
    b) des moyens de communication avec le téléphone intelligent, le serveur et l'infrastructure routière ;
    c) des moyens d'identification du véhicule
    d) des moyens d'alimentation et de stockage de l'énergie.

3. Système selon l'une des revendications 1 à 2 dans lequel les moyens de mesure comprennent un boîtier connecté et/ou un véhicule connecté et/ou une montre connectée.

4. Système selon l'une des revendications 1 à 3 dans lequel les moyens de calcul de l'empreinte polluante mettent en oeuvre un capteur physique embarqué pour des polluants locaux spécifiques.

5. Système selon l'une des revendications 1 à 4 dans lequel les moyens d'exploitation de l'empreinte polluante comprennent des moyens de communication avec l'infrastructure routière.

6. Système selon l'une des revendications 1 à 5 dans lequel l'objet connecté est une vignette « qualité de l'air » dynamique.

7. Système selon la revendication 6, dans lequel ladite vignette « qualité de l'air » communique directement l'empreinte environnementale à l'infrastructure routière pour l'accès de l'usager à des zones de circulation restreinte ou de stationnement préférentiel.

8. Système selon l'une des revendications 6 ou 7, dans lequel ladite vignette « qualité de l'air » affiche l'empreinte environnementale de l'usager, notamment au moyen d'un code couleur ou d'un indicateur.

9. Système selon la revendication 3 à 5 dans lequel l'objet connecté est intégré au téléphone intelligent ou au boîtier connecté ou au véhicule connecté ou à la montre connectée.

10. Procédé de détermination dynamique de l'empreinte environnementale liée à la mobilité d'un usager utilisant un système selon l'une des revendications 1 à 9 comprenant les étapes suivantes :

a) Mesure du déplacement de l'usager par une application sur téléphone intelligent détectant les mobilités douces et les mobilités en véhicule motorisé, ainsi que le style de conduite ;

b) Calcul de l'empreinte polluante de l'usager pour une fenêtre temporelle donnée tenant compte de l'usage réel et des polluants globaux et locaux émis pendant cette fenêtre temporelle ;

c) Affichage de l'empreinte environnementale liée à la mobilité de l'usager et information de l'usager et des autorités administratives par connexion cellulaire ou sans fil.

11. Procédé selon la revendication 10 dans lequel le calcul de l'empreinte polluante est effectué par agrégation de l'ensemble des émissions polluantes liées aux polluants locaux et globaux dans un seul référentiel, ledit référentiel étant obtenu en réalisant une somme pondérée des émissions de chaque polluant considérés en gramme par kilomètre, lesdits coefficients de cette somme pondérée étant choisis en fonction de leur impact sur la santé et l'environnement.

12. Procédé selon la revendication 10 ou 11 dans lequel, pour le calcul de l'empreinte polluante, on calcule les émissions de polluants liées au véhicule motorisé utilisé par l'usager en acquérant au moins un paramètre macroscopique relatif à la conception dudit véhicule, et en construisant pour ledit véhicule :

i) un modèle dudit véhicule qui relie ladite position et/ou l'altitude et/ou la vitesse dudit véhicule au couple et au régime dudit moteur au moyen d'au moins un paramètre macroscopique ;

ii) un modèle dudit moteur qui relie ledit couple et ledit régime dudit moteur aux émissions de polluants en sortie dudit moteur au moyen d'au moins un paramètre macroscopique ; et

iii) optionnellement un modèle dudit système de post-traitement qui relie lesdites émissions de polluants en sortie dudit moteur au moyen aux émissions de polluants en sortie dudit système de post-traitement au moyen d'au moins un paramètre macroscopique ;

et en réalisant les étapes suivantes :

a) on mesure la position, l'altitude et la vitesse dudit véhicule au moyen d'un système de géolocalisation ou d'un téléphone portable ;

b) on détermine ledit couple (Cme) et ledit régime (Ne) dudit moteur au moyen dudit modèle de véhicule et desdites mesures ;

c) on détermine les émissions de polluants en sortie dudit moteur au moyen dudit modèle du moteur et dudit couple (Cme) et dudit régime (Ne) dudit moteur ; et

d) éventuellement on détermine les émissions de polluants du véhicule au moyen dudit modèle du système de post-traitement et desdites émissions de polluants en sortie dudit moteur.

13. Procédé selon l'une des revendications 10 à 12 dans lequel on calcule d'abord une empreinte polluante pour chaque trajet j, puis on calcule une empreinte polluante moyenne pour l'ensemble des n trajets intervenus sur ladite fenêtre temporelle, comprenant ou non les trajets en mobilités douces, j étant un entier allant de 1 à n.

14. Procédé selon l'une des revendications 10 à 13 dans lequel ladite fenêtre temporelle est comprise entre 1 jour et 1 mois.

15. Procédé selon l'une des revendications 10 à 14 dans lequel les polluants globaux sont choisis parmi le dioxyde de carbone et les autres gaz à effet de serre et les polluants locaux sont choisis parmi les oxydes d'azote, le monoxyde de carbone, les particules fines, les hydrocarbures imbrûlés, le dioxyde de soufre.

| 1 | 2 | 3 |
|---|---|---|
| App | S | Ve / |
| + | + | + |
| B | Capt | Com |
| + | | |
| C | | |
| + | | |
| W | | |

**FIG. 1**

**FIG.2**

Europäisches
Patentamt

European
Patent Office

Office européen
des brevets

**RAPPORT DE RECHERCHE EUROPEENNE**

Numéro de la demande

EP 18 18 5890

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2007/104982 A2 (AIRMAX GROUP PLC [GB]; DUDDLE ASHLEY ROBERT [GB]; PERHAM STEPHEN HENRY) 20 septembre 2007 (2007-09-20) <br> * page 2, lignes 20-27 * <br> * page 3, ligne 29 - page 4, ligne 3 * <br> * page 10, lignes 16-20 * <br> * page 11, lignes 4-7 * <br> * page 13, lignes 22-30 * <br> * page 14, lignes 7-29 * <br> * page 18, lignes 3-8, 13-16, 20-22 * <br> * page 27, lignes 4-9 * <br> * page 28, ligne 23 - page 29, ligne 1 * <br> * page 31, lignes 7-25 * <br> ----- | 1-15 | INV. <br> G06Q50/30 <br> B60W40/09 |
| | | | DOMAINES TECHNIQUES RECHERCHES (IPC) |
| | | | G06Q <br> G07C <br> B60W |

Le présent rapport a été établi pour toutes les revendications

| Lieu de la recherche | Date d'achèvement de la recherche | Examinateur |
|---|---|---|
| Munich | 22 octobre 2018 | Aupiais, Brigitte |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................................
& : membre de la même famille, document correspondant

EPO FORM 1503 03.82 (P04C02)

**EP 3 462 405 A1**

## ANNEXE AU RAPPORT DE RECHERCHE EUROPEENNE
### RELATIF A LA DEMANDE DE BREVET EUROPEEN NO.

EP 18 18 5890

22-10-2018

| Document brevet cité au rapport de recherche | Date de publication | Membre(s) de la famille de brevet(s) | Date de publication |
|---|---|---|---|
| WO 2007104982 A2 | 20-09-2007 | US 2011106370 A1<br>WO 2007104982 A2 | 05-05-2011<br>20-09-2007 |

EPO FORM P0460

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3049653
- US 2004093264 A
- WO 14062429 A
- WO 2016142733 A
- US 20090069999 A
- US 20140039988 A
- CN 205010009 U